(19) Europäisches Patentamt

European Patent Office

Office européen des brevets

(11) Veröffentlichungsnummer: **0 304 612 B1**

## (12) EUROPÄISCHE PATENTSCHRIFT

(45) Veröffentlichungstag der Patentschrift: **29.07.92**

(21) Anmeldenummer: **88111540.6**

(22) Anmeldetag: **18.07.88**

(51) Int. Cl.⁵: **H05K 9/00**

(54) **Abdeckung zur elektromagnetischen Abschirmung von Öffnungen.**

(30) Priorität: **30.07.87 DE 3725306**

(43) Veröffentlichungstag der Anmeldung:
**01.03.89 Patentblatt 89/09**

(45) Bekanntmachung des Hinweises auf die
Patenterteilung:
**29.07.92 Patentblatt 92/31**

(84) Benannte Vertragsstaaten:
**AT BE CH DE ES FR GB GR IT LI LU NL SE**

(56) Entgegenhaltungen:
**EP-A- 0 159 407**
**DE-C- 3 611 693**
**DE-U- 8 205 425**
**GB-A- 909 009**

(73) Patentinhaber: **SIEMENS AKTIENGESELL-
SCHAFT**
**Wittelsbacherplatz 2**
**W-8000 München 2(DE)**

(72) Erfinder: **Wäger, Johann, Dipl.-Ing. (FH)**
**Birkensteige 6**
**W-8535 Emskirchen(DE)**
Erfinder: **Fumy, Albert, Dipl.-Ing. (FH)**
**Willigisstrasse 4**
**W-8500 Nürnberg(DE)**

## Beschreibung

Die Erfindung bezieht sich auf eine Abdeckung zur elektromagnetischen Abschirmung insbesondere von Fenster- und Türöffnungen, welche aus einem elektromagnetisch leitenden Material besteht und im geschlossenen Zustand über einen umlaufenden Schacht zur Aufnahme von Kontaktelementen die Öffnung elektromagnetisch abdichtet.

Abdeckungen dieser Art werden bevorzugt dazu benötigt, um die Tür- und Fensteröffnungen von elektromagnetisch abgeschirmten Räumen, Kabinen bzw. Schränke elektromagnetisch dicht abzuschließen. Bei solchen Räumen kann es sich z.B. um Laborkabinen handeln, deren Innenraum von äußeren elektromagnetischen Störeinflüssen abgeschirmt werden soll. Desweiteren können in solchen Kabinen auch Vorrichtungen untergebracht sein, die selbst eine starke Quelle von elektromagnetischen Störungen darstellen. So muß z.B. die von einem Kernspintomographen während der sogenannten Sendephase hervorgerufene Abstrahlung durch eine elektromagnetisch dichte Umbauung desselben an einer großräumigen Ausbreitung gehindert werden. Ferner müssen hochfrequente Störungen des Umfeldes vom Kernspintomographen ferngehalten werden, damit dessen Meßergebnis nicht verfälscht wird.

Aus der europäischen Patentanmeldung mit der Veröffentlichungsnummer 0 159 407 ist bereits eine Kontaktvorrichtung zur elektromagnetischen Abdichtung gegeneinander beweglicher Bauteile von elektromagnetisch geschirmten Räumen oder Kabinen, insbesondere von Türen oder Fenstern, bekannt. Diese Kontaktvorrichtung besteht aus einem Federschacht mit eingelegten Kontaktfedern, in die im geschlossenen Zustand ein bevorzugt auf dem Rand der abzudichtenden Tür- bzw. Fensteröffnung angebrachter messerartiger Fortsatz eingreift und somit eine leitende, hochfrequenzdichte Verbindung herstellt.

Bekannte Abdeckungen für Fenster- und Türöffnungen bestehen häufig aus einer Vielzahl von einzelnen Bauelementen, welche über leitende, insbesondere durch Verschweißung gebildete Materialverbindungen hochfrequenzdicht miteinander verbunden werden müssen. So sind bei solchen Abdeckungen insbesondere in den kritischen Randbereichen häufig die gesamte Abdeckung umlaufende und ringförmig geschlossene Schweißverbindungen notwendig. Jede Schweißverbindung bildet aber trotz sorgfältiger Ausführung in der Regel unvermeidlich eine Störungs- bzw. Schwachstelle im elektromagnetischen Schirm der Abdeckung.

Der Erfindung liegt somit die Aufgabe zugrunde, eine Abdeckung zur elektromagnetischen Abschirmung insbesondere von Fensterund Türöffnungen anzugeben, welche auch bei möglichst einfacher und homogener Gestaltung eine starke Dämpfung elektromagnetischer, hochfrequenter Störfelder bewirkt.

Die Aufgabe wird gelöst durch zwei ineinanderliegende Wannen, wobei die Wannenböden über Abstandselemente miteinander verbunden einen Hohlraum und die Wannenseiten den umlaufenden Schacht bilden.

Diese erfindungsgemäße zweischalige Abdeckung zeichnet sich im besonderem Maße dadurch aus, daß durch die Verwendung von einem Minimum an möglichst homogenen und wenig unterbrochenen Bauteilen die Dämpfungseigenschaften gegenüber elektromagnetischen Störungen besonders begünstigt werden. So kommt die erfindungsgemäße Abdeckung, abgesehen von den die Dämpfungseigenschaften nur wenig beeinflußenden Abstandselementen im Inneren, mit nur zwei aus leitfähigem Material bestehenden, ineinanderliegenden und auf Abstand gesetzten wannenförmigen Teilen aus. Die Anzahl und Länge von nachträglich insbesondere durch Verschweißung auf den Außenseiten der Abdeckung herzustellenden leitenden Materialverbindungen ist somit auf ein Minimum reduziert. Insbesondere an den Übergängen der bevorzugt durch Abkröpfung aus den jeweiligen Wannenböden gebildeten Wannenseiten sind noch sehr kurze Schweißverbindungen an den Außenseiten notwendig. Da gegen werden keinerlei insbesondere die Gesamtabdeckung unter Umständen mehrfach umlaufende, geschlossene Schweißverbindungen benötigt, welche die Abschirmungsqualität in der Regel negativ beeinflussen. Desweiteren werden die Dämpfungseigenschaften der erfindungsgemäßen Abdeckung besonders durch den über die Abstandselemente zwischen den Wannen gebildeten und relativ tiefen Hohlraum begünstigt. Abhängig von einer konkreten Ausgestaltung der jeweiligen Abdeckung können die Wannenböden elektrisch isoliert über die Abstandselemente mechanisch miteinander verbunden sein, bzw. es kann u.U. auch jedes der Abstandselemente zusätzlich eine elektrisch leitende Verbindung zwischen den Wannenböden herstellen.

Es ist ein weiterer Vorteil der erfindungsgemäßen Abdeckung, daß durch die Seiten der beiden Wannen auf einfache Weise ein umlaufender und relativ tiefer Schacht zur Aufnahme von Kontaktelementen gebildet wird, mit dessen Hilfe die elektromagnetische Abdichtung der Abdeckung im geschlossenen Zustand auf konstruktiv einfache Weise bewerkstelligt werden kann. Schließlich verfügt die erfindungsgemäße Abdeckung aufgrund der Verbindung der beiden Wannen über die Abstandselemente bereits über eine so ausreichende mechanische Festigkeit, daß keinerlei zusätzliche Versteifungselemente bzw. Versteifungsrahmen an deren Außenseiten angebracht werden müssen. Mit Hilfe von zusätzlichen, bevorzugt an den Außenseiten der äußeren Wannen bzw. im Hohlraum zwischen den beiden Wannen verankerten Scharnieren läßt sich die erfindungsgemäße Abdeckung besonders vorteilhaft als elektromagnetisch dichte Tür bzw. Fenster für elektromagnetisch abgeschirmte Räume bzw. Kabinen verwenden.

Es hat sich gezeigt, daß die Güte der Abschirmung in einer weiteren Ausführungsform der Erfindung insbesondere dadurch weiter vergrößert werden kann, daß die beiden Wannen in einem solchen Abstand miteinander verbunden sind, daß die Tiefe des Hohlraumes annähernd der Breite des umlaufenden Schachtes entspricht. In einer weiteren Ausführungsform sind die beiden Wannen in einem solchen Abstand miteinander verbunden, daß die Tiefe des Hohlraumes größer ist als die Breite des umlaufenden Schachtes.

Schließlich ist es ein weiterer Vorteil der erfindungsgemäßen Abdeckung, daß der umlaufende Schacht in einer weiteren Ausgestaltung der Erfindung besonders dazu geeignet ist, in Form einer entsprechend der in der europäischen Patentanmeldung mit der Veröffentlichungsnummer 0 159 407 beschriebenen Kontaktvorrichtung ausgebildet zu sein. Dabei dienen bevorzugt Kontaktfedern und Kontaktmesser als Kontaktelemente, wobei im geschlossenen Zustand der Abdeckung die Kontaktmesser in die im umlaufenden Schacht angebrachten Kontaktfedern eingreifen.

Anhand der nachfolgend kurz angeführten Figuren wird die Erfindung desweiteren näher erläutert. Dabei zeigt:

FIG 1 eine vorteilhafte Ausführungsform einer unter Verwendung der erfindungsgemäßen zweischaligen Abdeckung aufgebauten elektromagnetisch dichten Tür, und

FIG 2 eine entlang der strichpunktierten Linie A-H geführte Schnittdarstellung durch die Tür gemäß der FIG 1.

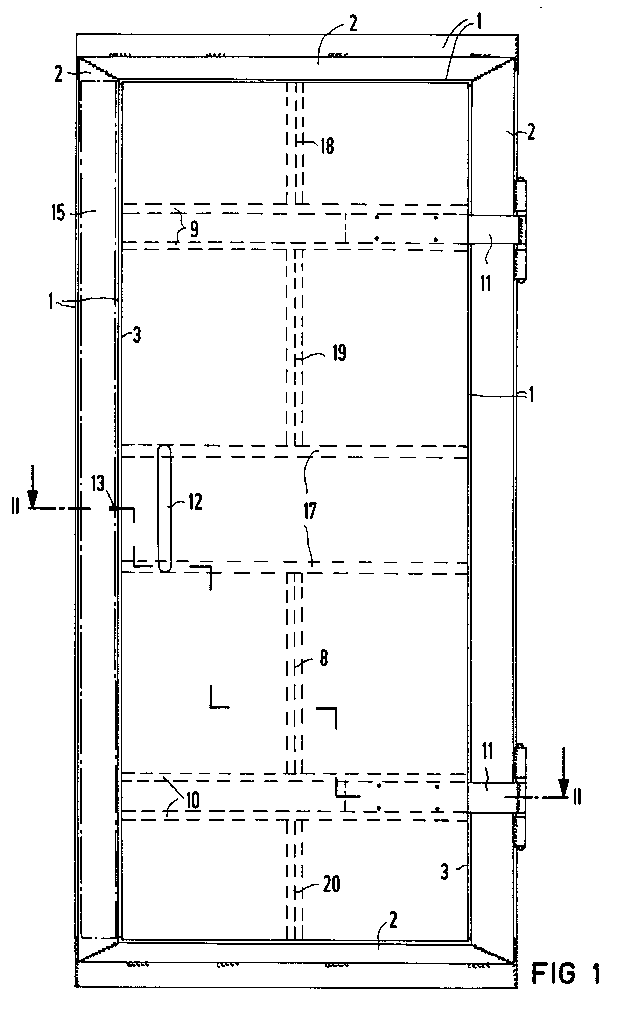

In der FIG 1 ist eine vorteilhafte Anwendung der erfindungsgemäßen Abdeckung in Form einer elektromagnetisch abschirmenden Tür dargestellt. Zur Abdeckung einer durch eine Türzarge 1 begrenzten Türöffnung dienen zwei ineinanderliegende Wannen 2 und 3, von denen in der FIG 1 die äußere Wanne 3 sichtbar dargestellt ist. Je ein im oberen bzw. unteren Türbereich angebrachtes und im Hohlraum zwischen den beiden Wannen verankertes Scharnier 11 ermöglicht zusammen mit einem Griff 12 ein leichtes Öffnen und Schließen der Tür. Falls erforderlich, kann zusätzlich auf den Außenseiten der Zarge 1 ein umlaufender Versteifungsrahmen 2 angebracht werden. Eine vorteilhafte Ausführungsform der im Hohlraum zwischen den beiden Wannenböden vorhandenen Abstandselemente ist in der FIG 1 mit strichlierten Linien dargestellt. Dabei dienen bevorzugt drei U-förmige und im Bereich der beiden Scharniere 11 bzw. des Türgriffes 12 angeordnete Abstandselemente 9,10 und 17 zur Versteifung der Abdeckung in Querrichtung. Falls es erforderlich ist, können bevorzugt in der Mitte des Hohlraumes zusätzliche Versteifungsprofile 18,19,8 und 20 senkrecht angeordnet werden. Zum Verschluß der Tür dient ein Bolzen 13, der in einen auf der Verschlußseite der Zarge 1 bevorzugt auf dem Versteifungsrahmen 2 zusätzlich angebrachten und zur Aufnahme einer nicht dargestellten Schließvorrichtung dienenden Schacht 15 eingreift.

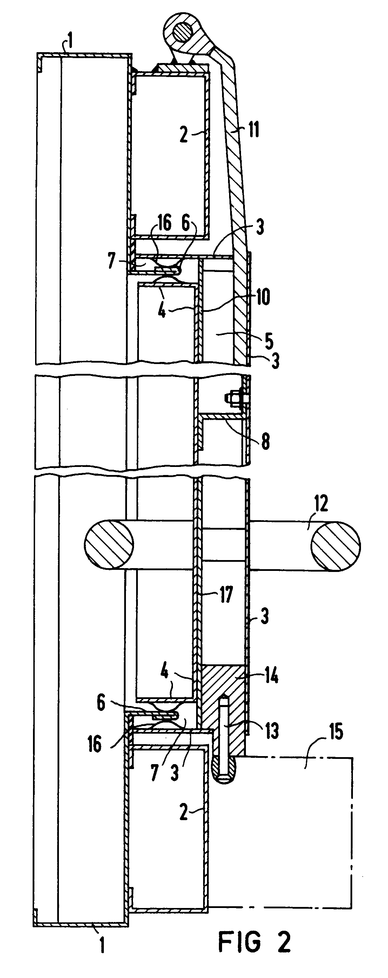

Die FIG 2 zeigt eine Schnittdarstellung durch die in FIG 1 dargestellte Tür, welche entlang der mit II markierten, strichpunktierten Linie geführt ist. Die beiden ineinanderliegenden, den Hohlraum 5 und den umlaufenden Schacht 7 zur Aufnahme der Kontaktelemente bildenden Wannen 3 und 4 der erfindungsgemäßen Abdeckung sind dabei im Querschnitt dargestellt. Es ist zu erkennen, daß entsprechend einer der weiteren Ausführungsformen der Erfindung die Breite des umlaufenden Schachtes 7 annähernd der Tiefe des Hohlraumes 5 entspricht. Die in der FIG 2 im Schnitt dargestellten Abstandselemente 10,17 und 8 bilden in dieser speziellen Ausführungsform auch eine elektrisch leitende Verbindung zwischen den Wannenböden.

Entsprechend einer weiteren Ausführungsform der Erfindung sind die Kontaktelemente im Inneren des umlaufenden Schachtes 7 als Kontaktfedern 16 ausgebildet und auf den nach innen gewandten Wannenseiten angebracht. In diese greifen die als Kontaktmesser 6 ausgebildeten und die Türöffnung begrenzenden Enden der Türzarge 1 so ein, daß die Tür in dem in der FIG 2 dargestellten geschlossenen Zustand die Türöffnung elektromagnetisch dicht abschließt.

Schließlich zeigt die FIG 2 im Schnitt ein Lager 14 zur Befestigung des Verschlußbolzens 13, der in nicht näher dargestellter Weise in eine bevorzugt im Schacht 15 angeordnete Schließvorrichtung eingreift.

## Patentansprüche

1. Abdeckung zur elektromagnetischen Abschirmung insbesondere von Fenster- und Türöffnungen, welche aus einem elektromagnetisch leitenden Material besteht und im geschlossenen Zustand über einen umlaufenden Schacht (7) zur Aufnahme von Kontaktelementen die Öffnung elektromagnetisch abdichtet, **gekennzeichnet** durch zwei ineinanderliegende Wannen (3, 4), wobei die Wannenböden über Abstandselemente (8,9,10,17,18, 19,20) miteinander verbunden einen Hohlraum (5) und die Wannenseiten den umlaufenden Schacht (7) bilden.

2. Abdeckung nach Anspruch 1, **dadurch gekennzeichnet,** daß die beiden Wannen (3,4) in einem solchen Abstand miteinander verbunden sind, daß die Tiefe des Hohlraumes (5) annähernd der Breite des umlaufenden Schachtes (7) entspricht.

3. Abdeckung nach Anspruch 1, **dadurch gekennzeichnet,** daß die beiden Wannen (3,4) in einem solchen Abstand miteinander verbunden sind, daß die Tiefe des Hohlraumes (5) größer ist als die Breite des umlaufenden Schachtes (7).

4. Abdeckung nach einem der Ansprüche 1 bis 3, **gekennzeichnet** durch Kontaktfedern (16) und Kontaktmesser (6) als Kontaktelemente, wobei im geschlossenen Zustand die Kontaktmesser in die im umlaufenden Schacht (7) angebrachten Kontaktfedern eingreifen.

## Claims

1. Covering for electromagnetic shielding, in particular for window and door openings, which comprises an electromagnetically conductive material and in the closed position seals the opening electromagnetically by means of a circumferential hollow (7) for receiving contact elements, characterized by two interlying tanks (3, 4), whereby the tank floors, connected to one another by way of spacing elements (8,9,10,17,18,19,20) form a cavity (5) and the tank sides form the circumferential hollow (7).

2. Covering according to claim 1, characterized in that the two tanks (3,4) are connected to one another with such a spacing that the depth of the cavity (5) corresponds approximately with the width of the circumferential hollow (7).

3. Covering according to claim 1, characterized in that the two tanks (3,4) are connected to one another with such a spacing that the depth of the cavity (5) is greater than the width of the circumferential hollow (7).

4. Covering according to one of claims 1 to 3, characterized by contact springs (16) and contact pins (6) as contact elements, whereby in the closed position the contact pins engage into the contact springs fitted in the circumferential hollow (7).

## Revendications

1. Capot pour réaliser le blindage électromagnétique notamment d'ouvertures de fenêtres et de portes, qui est réalisé en un matériau conducteur du point de vue électromagnétique et, à l'état fermé, ferme l'ouverture d'une manière étanche vis-à-vis des ondes électromagnétiques, par l'intermédiaire d'un logement enveloppant (7) servant à recevoir des éléments de contact, caractérisé par deux cuvettes (3,4) imbriquées l'une dans l'autre, dont les fonds, qui sont réunis entre eux par l'intermédiaire d'éléments d'entretoisement (8,9,10,17,18,20), forment une cavité (5), tandis que les côtés des cuvettes forment le logement enveloppant (7).

2. Capot suivant la revendication 1, caractérisé par le fait que les deux cuvettes (3,4) sont réunies entre elles à une distance telle que la profondeur de la cavité (5) correspond approximativement à la largeur du logement enveloppant (7).

3. Capot suivant la revendication 1, caractérisé par le fait que les deux cuvettes (3,4) sont réunies entre elles à une distance telle que la profondeur de la cavité (5) est supérieure à la largeur du logement enveloppant (7).

4. Capot suivant l'une des revendications 1 à 3, caractérisé par des ressorts de contact (16) et des couteaux de contact (6) formant éléments de contact, les couteaux de contact s'engageant, à l'état fermé, dans les ressorts de contact montés dans le logement enveloppant (7).

FIG 1

FIG 2